Europäisches Patentamt

European Patent Office

Office européen des brevets

(19)

(11) EP 0 681 370 B1

(12) FASCICULE DE BREVET EUROPEEN

(45) Date de publication et mention
de la délivrance du brevet:
**22.12.1999 Bulletin 1999/51**

(51) Int Cl.6: **H03K 19/0185**, H03K 19/017,
H03K 19/003

(21) Numéro de dépôt: **95400976.7**

(22) Date de dépôt: **28.04.1995**

(54) **Circuit CMOS de sortie pour circuit intégré**

CMOS-Ausgangsschaltung für integrierte Schaltung

CMOS output circuit for integrated circuit

(84) Etats contractants désignés:
**DE GB IT NL**

(30) Priorité: **03.05.1994 FR 9405387**

(43) Date de publication de la demande:
**08.11.1995 Bulletin 1995/45**

(73) Titulaire: **MHS**
**44087 Nantes Cédex 03 (FR)**

(72) Inventeurs:
• **Martinez, Raymond**
**F-44700 Orvault (FR)**

• **Bion, Thierry**
**F-44000 Nantes (FR)**

(74) Mandataire: **Fréchède, Michel et al**
**Cabinet Plasseraud**
**84, rue d'Amsterdam**
**F-75440 Paris Cédex 09 (FR)**

(56) Documents cités:
**FR-A- 2 614 743**

• **PATENT ABSTRACTS OF JAPAN vol. 14 no. 336
(E-953) [4279] ,19 Juillet 1990 & JP-A-02 113721
(MITSUBISHI ELECTIC CORP.)**

**Description**

L'invention concerne un circuit de sortie pour circuit intégré, de type TTL-CMOS.

Dans la technologie des circuits intégrés de type TTL-CMOS, les signaux d'entrée-sortie de type numérique doivent présenter un niveau logique haut et un niveau logique bas correspondant chacun à une valeur de tension électrique, reconnue chacune comme telle. De manière plus spécifique, chacune des tensions électriques précitées doit être comprise dans une plage de valeurs de tensions électriques, lesquelles sont chacune reconnues comme correspondant au niveau logique considéré.

Avec l'avènement des circuits intégrés les plus récents, les plages de valeurs précitées ont fait l'objet d'une redéfinition. En technologie TTL, le niveau logique haut correspond à une tension électrique supérieure à 1,5 volts, le niveau logique bas correspondant à une tension électrique comprise entre 1,5 volts et la tension de référence, la tension de masse du circuit. En technologie CMOS, le niveau logique haut correspond à une tension supérieure ou égale à 2,4 volts et le niveau logique bas à une tension comprise entre 0,4 volts et la tension de référence.

Outre l'intérêt majeur d'une réduction potentielle de la consommation d'énergie électrique par de tels circuits intégrés, consécutive à la diminution de l'amplitude de commutation entre les niveaux logiques précités, la consommation moyenne étant diminuée corrélativement, ces circuits sont susceptibles de permettre des temps de commutation plus brefs, et donc la mise en oeuvre de circuits plus rapides, pourvu que les tensions électriques définissant les niveaux logiques haut et bas précités correspondent à des valeurs de tension voisines des valeurs limites des plages de valeurs de définition des niveaux TTL-CMOS, respectivement au-delà et en-deçà de celles-ci, ce qui permet de réduire en conséquence le temps de commutation de l'un à l'autre des niveaux.

De tels circuits sont connus de l'état de la technique.

En particulier, le document FR-A-2 614 743 décrit un circuit intégré à précharge active de la sortie comprenant un transistor PMOS et un transistor NMOS en parallèle, connectés en cascade avec une branche semblable comprenant un transistor NMOS. Toutefois, le processus de précharge décrit par ce document est réalisé grâce à une détection du signal d'entrée, compte tenu du signal de sortie.

En outre, le document Patent Abstracts of Japan, Vol.14, No. 336, 19 juillet 1990 et JP-A-02 113721 décrivent un dispositif de précharge de la sortie d'un circuit intégré dans lequel la plage de variation du signal de sortie est réduite, le niveau bas du signal de sortie étant maintenu à un niveau inférieur à celui du niveau haut, mais proche de ce dernier, et de la tension d'alimentation.

La présente invention a pour objet la mise en oeuvre d'un circuit de sortie pour circuit intégré de type TTL-CMOS, permettant de réduire le temps de commutation entre niveau logique haut et niveau logique bas et réciproquement, à partir de deux signaux de validation de commutation, ce qui permet d'augmenter en conséquence la rapidité de commutation entre les niveaux précités.

Un autre objet de la présente invention est également, grâce à la diminution de l'amplitude de commutation entre niveau logique haut et niveau logique bas, et réciproquement, de diminuer en conséquence le niveau de bruit de commutation engendré.

Le circuit de sortie pour circuit intégré de type TTL-CMOS, objet de la présente invention, est conforme à la revendication 1.

L'invention trouve application à la fabrication des circuits intégrés en technologie CMOS sub-micronique pour l'obtention de circuits rapides dont le temps de commutation est compris entre 4 et 6 nanosecondes.

Elle sera mieux comprise à la lecture de la description et à l'observation des dessins ci-après dans lesquels :

- la figure 1 représente un schéma fonctionnel du circuit de sortie pour circuit intégré, objet de la présente invention ;

- la figure 2a représente un mode de réalisation avantageux du premier circuit de commande du transistor MOS de type P inclus dans l'étage de sortie du circuit de sortie pour circuit intégré tel que représenté en figure 1 ;

- la figure 2b représente un deuxième circuit de commande du transistor MOS de type N en cascade avec les transistors MOS P et N en parallèle, mis en oeuvre dans le circuit de sortie pour circuit intégré tel que représenté en figure 1 ;

- la figure 2c représente un mode de réalisation avantageux d'un troisième circuit de commande du transistor MOS de type N, en parallèle sur le transistor MOS de type P, inclus dans l'étage de sortie du circuit de sortie pour circuit intégré tel que représenté en figure 1 ;

- la figure 3 représente un ensemble de chronogrammes relevés aux points de test de la figure 1.

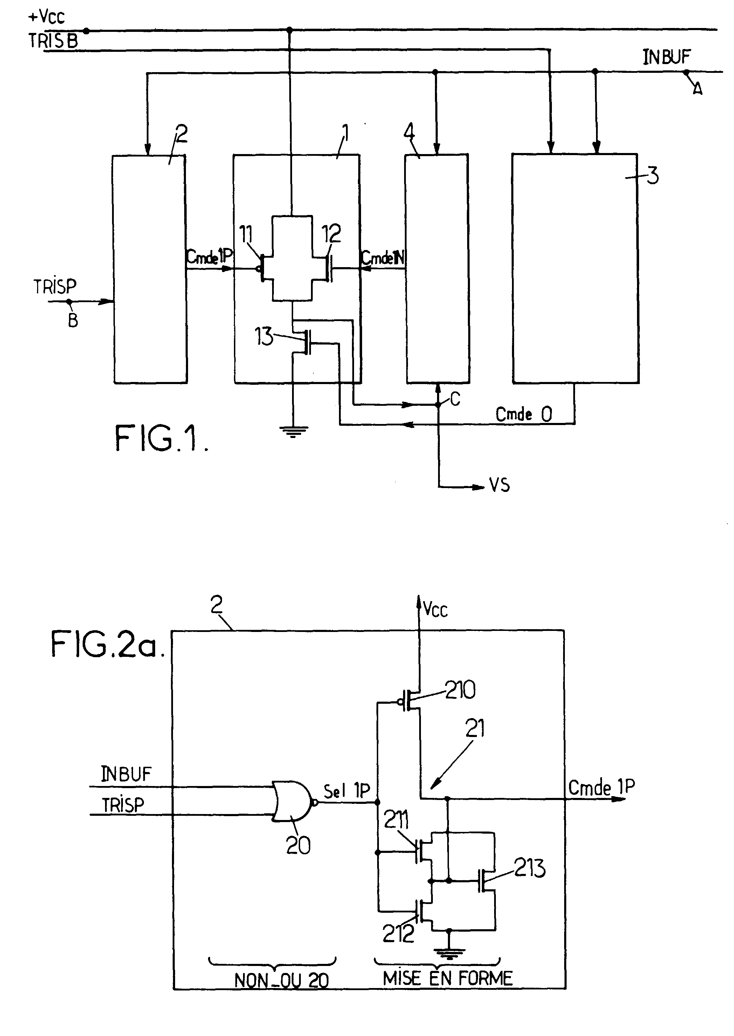

Une description plus détaillée d'un circuit de sortie pour circuit intégré de type TTL-CMOS objet de la présente invention, sera maintenant donnée en liaison avec la figure 1.

D'une manière générale, on indique que le circuit de sortie pour circuit intégré objet de la présente invention est compatible avec les normes de signaux en technologie TTL respectivement en technologie CMOS, les signaux ainsi délivrés par le circuit de sortie pour circuit intégré étant reconnus comme niveau logique haut respectivement niveau logique bas par tout circuit connecté en sortie du circuit de sortie pour circuit intégré

objet de la présente invention, de type TTL ou de type CMOS, les signaux de sortie ainsi délivrés par le circuit de sortie pour circuit intégré objet de la présente invention, satisfaisant bien sûr à la fois à la norme TTL et à la norme CMOS précédemment mentionnées dans la description.

Ainsi qu'on l'observera sur la figure 1, on indique que le circuit de sortie pour circuit intégré, objet de la présente invention, comprend un circuit d'entrée d'une variable logique à un niveau haut respectivement à un niveau bas. Ce circuit d'entrée correspond au point de test A sur la figure 1, le signal représentatif de la variable logique précitée étant noté INBUF. On comprend bien sûr que ce signal d'entrée peut être délivré par un circuit intégré incorporant le circuit de sortie objet de la présente invention. En particulier, ce circuit intégré peut être équipé de modules de mémorisation de la variable logique précitée, ce circuit de mémorisation pouvant être constitué par une mémoire tampon, non représentée sur la figure 1.

Ainsi qu'on l'observera sur la figure précitée, le circuit de sortie pour circuit intégré objet de l'invention, comprend un étage de sortie, noté 1, formé par un transistor MOS de type P, noté 11, et un transistor MOS de type N, noté 12, connectés en parallèle, l'ensemble des deux transistors en parallèle précités étant connecté en cascade avec un transistor MOS de type N, ce transistor étant noté 13, les transistors en parallèle 11, 12 et le transistor en cascade 13 avec les deux transistors précités étant connectés entre la tension d'alimentation, notée VCC, et la tension de référence constituant la tension de masse du circuit de sortie et bien entendu du circuit intégré incorporant celui-ci.

L'étage de sortie 1, conformément à un aspect particulièrement avantageux du circuit de sortie objet de la présente invention, peut être connecté ou non connecté par l'intermédiaire des transistors 11, 12 et 13 et d'un premier signal de validation de commutation, noté TRISP, l'étage de sortie 1 délivrant un signal de sortie Vs en un point de sortie constitué par le point commun entre le transistor MOS de type N, noté 13, et les transistors MOS de type P respectivement N, 11, 12, connectés en parallèle.

En outre, le circuit de sortie objet de l'invention comprend un premier circuit de commande de commutation du transistor MOS de type P, noté 11, ce premier circuit de commande portant la référence 2 sur la figure 1. Le premier circuit de commande de commutation 2 est connecté au circuit d'entrée de la variable logique et reçoit ainsi le signal représentatif de cette variable logique INBUF ainsi que le premier signal de validation de commutation, noté TRISP.

Sur la figure 1, on indique que les points de test A, B, C correspondent respectivement à un point d'entrée du signal représentatif de la variable logique INBUF, au premier signal de validation de commutation TRISP, respectivement au signal de sortie, noté Vs, au point de sortie de l'étage de sortie 1.

En outre, ainsi qu'on l'a représenté sur la figure 1, le circuit de sortie objet de la présente invention, comprend un deuxième circuit 3 de commande du transistor MOS de type N, noté 13, ce circuit 3 de commande recevant d'une part, un deuxième signal de validation de commutation désigné par TRISB et bien entendu le signal représentatif de la variable logique INBUF, et délivrant un signal de commande du transistor MOS N 13, ce signal de commande portant la référence Cmde0. Le signal de commande du transistor 13 permet, grâce à la mise en conduction du transistor MOS de type N, d'imposer la valeur de la tension de sortie Vs à une valeur très voisine de la tension de référence, c'est-à-dire en fait d'imposer la valeur 0 au niveau logique bas pour le signal de sortie Vs lorsque le transistor 13 est à l'état de conduction, ainsi qu'il sera décrit de manière plus détaillée ultérieurement dans la description.

Enfin, le circuit de sortie objet de la présente invention, comprend également un troisième circuit de commande de commutation du transistor MOS de type N 12, connecté en parallèle avec le transistor MOS de type P 11 de l'étage de sortie 1, ce troisième circuit de commande, noté 4, opérant en contre-réaction sur le signal de sortie de l'étage de sortie, ainsi qu'il sera décrit ci-après dans la description.

D'une manière générale, on indique que les premier et troisième circuits de commande de commutation 2 et 4 sont commandés successivement à partir de la transition d'un niveau logique haut à un niveau logique bas, et réciproquement, en ce qui concerne le deuxième circuit de commande de commutation 3 d'un niveau logique bas à un niveau logique haut du signal représentatif de la variable logique INBUF ainsi qu'il sera décrit ci-après dans la description.

Ce mode de commande permet d'engendrer un niveau de commutation intermédiaire appartenant au niveau logique haut, ce qui permet d'améliorer le temps de commutation résultant entre niveaux lors du passage du niveau logique haut au niveau logique bas, ainsi qu'il sera décrit ci-après.

Une description plus détaillée du premier circuit de commande de commutation 2 sera maintenant donnée en liaison avec la figure 2a.

Selon la figure précitée, on indique que le premier circuit de commande de commutation 2 comporte, connecté en cascade, un circuit de type NON-OU, noté 20, recevant sur ses entrées de commande de commutation le signal représentatif de la variable logique INBUF et le premier signal de validation de commutation, noté TRISP, pour délivrer un signal de pré-commande de commutation intermédiaire, noté sel1P sur la figure 2a précitée.

Le premier circuit de commande de commutation 2 comporte également un circuit 21 de mise en forme du signal de pré-commande de commutation intermédiaire sel1P, le circuit de mise en forme 21 recevant le signal précité sel1P et délivrant à l'électrode de grille du transistor MOS de type P 11 de l'étage de sortie 1, un signal de commande de commutation intermédiaire positif, noté cmde 1P. On indique que la désignation de signal de commande de commutation intermédiaire positif est donnée en référence à la commande du transistor MOS de type P et non pas relativement à la polarité effective du signal de commande considéré.

Le circuit de mise en forme 21 est formé par une structure inverseuse recevant le signal de pré-commande intermédiaire sel1P. Elle comprend trois transistors de type N 211, 212, 213, les transistors 211, 212 étant connectés en cascade, leur grille étant commandée en parallèle par le signal sel1P, le transistor 213 étant connecté en parallèle sur la cascade formée par les transistors 211, 212, la grille du transistor 213 étant reliée au point commun des transistors 211 et 212. Un transistor MOS de type P 210 dont la grille est connectée en sortie de la porte NON-OU 20, recevant le signal sel1P, est connecté entre la tension d'alimentation VCC et le point commun des transistors MOS 211 et 212 et délivre le signal de commande de commutation intermédiaire positif cmde1P. La vitesse de commutation niveau logique haut - niveau logique bas en sortie du circuit de mise en forme 21 s'auto-régule grâce aux trois transistors de type N 211, 212 et 213. Pendant la première phase de commutation, le signal cmde1P est à l'état de niveau logique haut, les trois transistors précités étant à l'état de conduction. C'est la phase dite "rapide" de commutation du signal cmde1P. Lorsque ce signal atteint la tension de seuil de conduction, le transistor 213 se bloque, seul le transistor 212 restant à l'état de conduction. C'est la phase dite "lente" de commutation du signal cmde1P.

On indique que le circuit de type NON-OU 20 peut être réalisé en technologie CMOS à l'aide de transistors intégrés, le schéma pouvant correspondre à une porte de type NON-OU classique, laquelle, à ce titre, ne sera pas décrite en détail.

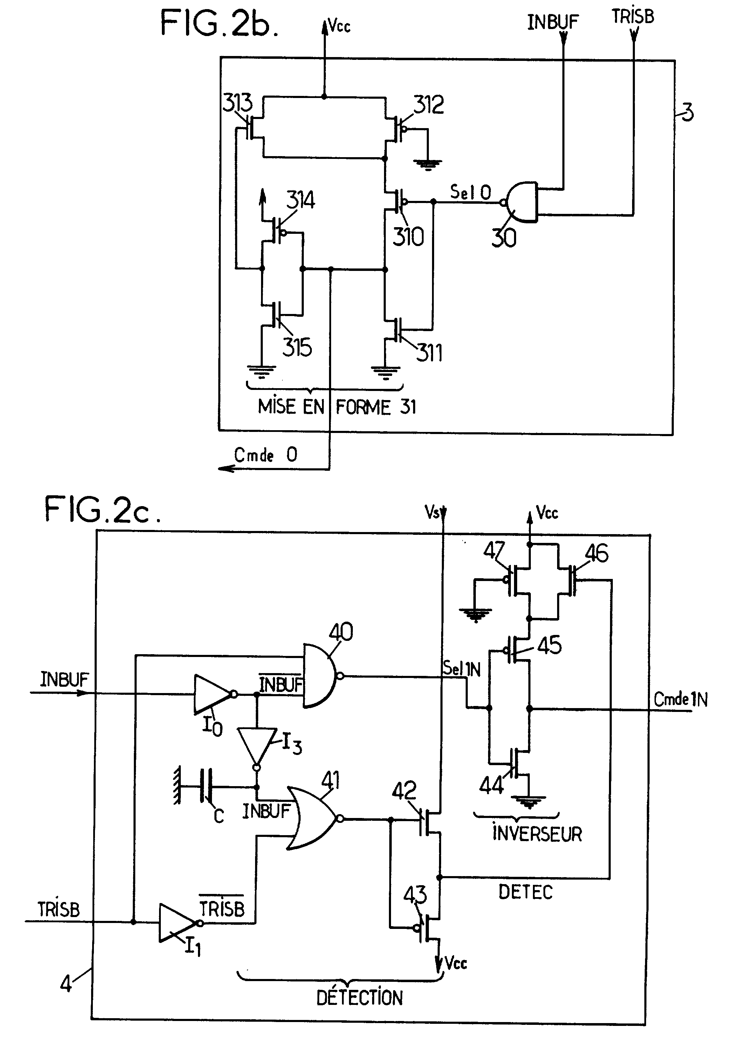

Une description plus détaillée du deuxième dispositif de commande 3 du transistor 13 de type N sera maintenant donnée en liaison avec la figure 2b.

Le deuxième circuit de commande du transistor précité, ainsi que représenté sur la figure précitée, comprend une porte de type NON-ET, référencée 30, recevant sur ses entrées le signal représentatif de la variable logique INBUF et le deuxième signal de validation de commutation TRISB. La porte 30 de type NON-ET délivre un signal correspondant désigné par Sel0.

En outre, le circuit de commande du transistor N 13 comprend également un circuit de mise en forme, noté 31, constitué par une structure de type inverseur. Cette structure de type inverseur comprend, ainsi que représenté sur la figure 2b précitée, deux transistors MOS de type P connectés en cascade avec un transistor MOS de type N entre la tension d'alimentation VCC et la tension de référence, les deux transistors MOS de type P portant la référence 312 et 310 et le transistor MOS de type N portant la référence 311. Les transistors MOS de type P 310 et de type N 311 reçoivent sur leur électrode de grille le signal sel0 délivré par la porte de type NON-ET 30.

La structure inverseuse et de mise en forme 31 comprend en outre un transistor MOS de type N 313 connecté en parallèle sur le transistor MOS de type P 312 et un étage inverseur proprement dit, formé par un transistor MOS de type P 314, et un transistor MOS de type N 315 connectés en cascade et dont les électrodes de grille sont commandées en parallèle par le point commun entre les transistor MOS de type P 310 et de type N 311. L'étage inverseur proprement dit formé par les transistors MOS de type P 314 et de type N 315, est connecté entre la tension d'alimentation VCC et la tension de référence, le point commun entre les transistors 314 et 315 étant relié à l'eléctrode de grille du transistor MOS de type N 313. Le point commun entre les transistors MOS de type P 310 et de type N 311 forment le point de sortie du circuit de commande du transistor N 13, ce point de sortie délivrant le signal, noté cmde0, lequel est délivré à l'électrode de grille du transistor N 13. Ce signal est donc engendré par la structure inverseuse représentée en figure 2b. La vitesse de commutation, entre le niveau logique bas et le niveau logique haut en sortie de la structure inverseuse précitée, s'auto-régule grâce à l'inverseur formé par les transistors 315 et 314 de l'étage inverseur proprement dit ainsi que grâce aux transistors MOS de type N 313 et de type P 312 montés en parallèle. Pendant la première phase de commutation, le signal cmde0 délivré par le circuit de commande 3 du transistor N 13, est au niveau logique bas, les transistors MOS de type N 313 et de type P 312 étant à l'état de conduction, cet état correspondant à la phase dite "rapide" du signal de commande du transistor N 13, le signal cmde0. Lorsque le signal précité atteint la valeur de seuil de conduction, le transistor MOS de type N 313 se bloque par l'intermédiaire de l'étage inverseur proprement dit formé par les transistors MOS de type P 314 et par le transistor MOS N 315. Le transistor MOS de type P 312 est alors seul conducteur, ce qui correspond à une phase dite "lente" de commutation du signal de commande du transistor N 13, le signal cmde0.

Ainsi que mentionné précédemment dans la description, on indique que le transistor N 13 permet d'une part, par commutation, de contribuer à la mise en et hors circuit de l'étage de sortie 1 à partir du deuxième signal de validation de commutation noté TRISB, ainsi que de fixer, pour le point de sortie et en définitive pour le signal de sortie Vs, la valeur du zéro, c'est-à-dire du niveau logique bas de ce signal de sortie à la tension de référence, à la tension de saturation près du transistor 13 précité.

En ce qui concerne le troisième circuit de commande de commutation du transistor MOS de type N 12, ce circuit portant la référence 4 permet d'opérer en contre-réaction de la tension de sortie Vs ainsi que mentionné précédemment dans la description.

Une description plus détaillée du troisième circuit de commande 4 sera maintenant donnée en liaison avec la figure 2c.

Ainsi que représenté sur la figure précitée, le troisième circuit de commande de commutation du transistor MOS de type N 12 comprend un circuit de type logique NON-ET 40 recevant sur ses entrées, d'une part, le deuxième signal de validation de commutation TRISB précédemment décrit, permettant la commande de commutation du transistor N 13 et d'autre part, le signal complémenté représentatif de la variable logique, ce signal étant noté $\overline{\text{INBUF}}$. On indique à titre d'exemple que ce signal peut être obtenu à partir du signal représentatif de la variable logique INBUF par l'intermédiaire d'un inverseur noté I0. Le circuit logique de type NON-ET 40 délivre à partir des signaux précités un signal correspondant, noté sel1N.

Le troisième circuit de commande de commutation 4 du transistor MOS de type N comporte également un étage de détection de la tension de sortie Vs délivrée par l'étage de sortie 1, cet étage de détection étant constitué, ainsi que représenté sur la figure 2c, par une porte logique de type NON-OU 41, laquelle reçoit sur ses entrées de commutation le signal représentatif de la variable logique INBUF et le signal de validation de commutation complémenté, noté $\overline{\text{TRISB}}$, ce signal étant obtenu à partir du signal de validation de commutation TRISB par l'intermédiaire d'un inverseur I1. Le circuit logique de type NON-OU 41 délivre à sa sortie un signal correspondant. De manière spécifique, on indique que le signal INBUF représentatif de la variable logique à l'entrée de la porte logique de type NON-OU 41 est obtenu à partir du signal complémenté correspondant délivré par le premier inverseur I0 par l'intermédiaire d'un troisième inverseur noté I3, lequel permet de restituer le signal représentatif de la variable logique INBUF inchangé mais retardé du double temps de commutation de chaque inverseur I0 et I3.

En outre, l'étage de détection comprend un circuit de type inverseur formé par deux transistors MOS connectés en cascade, un transistor MOS de type N 42 et un transistor MOS de type P 43, lesquels sont connectés entre la sortie de l'étage de sortie 1 recevant de ce fait la tension de sortie Vs, et la tension de référence, la grille des transistors MOS de type N 42 et P 43 étant alimentée en parallèle par la sortie de la porte NON-OU 41. Le point commun des transistors MOS de type N 42 et P 43 formant le circuit inverseur précité permet ainsi de délivrer un signal détecté, noté detec, lequel est représentatif de la détection de la tension de sortie Vs.

Le troisième circuit de commande de commutation 4 comporte enfin une structure de type inverseur permettant d'engendrer le signal de commande de commutation du transistor MOS de type N 12, ce signal étant noté cmde1N. Le signal de commande du transistor MOS N 12 est dit signal de commande de commutation intermédiaire négatif en référence au type de conduction du transistor MOS 12. Cette structure de type inverseur, ainsi que représentée sur la figure 2c, comprend un inverseur proprement dit formé par deux transistors MOS de type N 44 et de type P 45 connectés en cascade, la grille des transistors MOS N 44 et P 45 étant connectée en parallèle et recevant le signal sel1N délivré par la porte NON-ET 40. L'étage inverseur de sortie précité est en outre connecté en cascade avec un étage de commutation formé par deux transistors MOS en parallèle, transistor MOS N 46 et transistor MOS P 47, lesquels sont connectés entre la tension d'alimentation VCC et le transistor MOS de type P 45 formant étage inverseur de sortie avec le transistor MOS N 44. L'électrode de grille du transistor MOS P 47 est reliée à la tension de référence et l'électrode de grille du transistor MOS N 46 est reliée au point commun des transistors MOS P 43 et N 42 du circuit inverseur de l'étage de détection, l'électrode de grille du transistor MOS N 46 recevant ainsi le signal détecté, signal noté detec. Le point commun des transistors MOS N 44 et P 45 du circuit inverseur de sortie délivre le signal de commande de commutation du transistor MOS N 12, signal noté cmde1N.

La vitesse de commutation de l'état logique bas à l'état logique haut en sortie de la structure inverseuse et plus particulièrement du circuit inverseur de sortie formé par les transistors MOS N 44 et P 45, est ajustable par l'intermédiaire du signal détecté detec, ce signal pouvant prendre deux états, soit l'état du signal de sortie Vs, cet état étant conféré au signal détecté detec par l'intermédiaire du transistor MOS N 42, soit l'état de la valeur de la tension d'alimentation VCC par l'intermédiaire du transistor MOS P 43 lorsque ce transistor est rendu conducteur. La commande des transistors P 43 et N 42 est effectuée par le signal délivré par la porte NON-OU 41. Lorsque le signal représentatif de la variable logique INBUF passe du niveau logique haut au niveau logique bas, la transition correspondante à l'entrée de la porte NON-OU 41 est retardée par les deux inverseurs I0 et I3 et, le cas échéant, par une capacité notée C, laquelle, à titre d'exemple non limitatif, peut être réalisée par un transistor MOS monté en capacité par exemple. Le signal de sortie délivré par la porte NON-OU 41 reste de ce fait au niveau logique bas et provoque la conduction du transistor MOS P 43, lequel maintient le signal de détection detec à la valeur de la tension d'alimentation VCC. Le transistor MOS N 46 est alors commandé à l'état de conduction, le transistor MOS N 42 étant à l'état bloqué alors que le transistor MOS P 47 est lui-même à l'état de conduction. L'état précité correspond à une première phase dite "rapide" du signal de commande de commutation du transistor MOS N 12, soit du signal cmde1N.

Au bout d'un temps de retard déterminé par les inverseurs I0 et I3 et par la capacité C, le niveau logique bas du signal représentatif de la variable logique INBUF apparaît sur l'entrée de la porte NON-OU 41, ce qui provoque le basculement du signal de sortie délivré par celle-ci vers le niveau logique haut. Le transistor MOS N 42 devient conducteur, amenant ainsi le signal détecté detec à la valeur du signal de sortie Vs. Suite à la commutation précitée, le signal de sortie Vs est inférieur au seuil de conduction du transistor MOS N 46, lequel passe de l'état de conduction à l'état bloqué. Le transistor MOS P 47 est alors seul conducteur, cet état correspondant à une deuxième phase dite "lente" du signal de commande de commutation du transistor MOS N 12, signal noté cmde1N.

Au fur et à mesure que le signal de sortie Vs évolue vers le niveau logique haut, le signal de détection de commutation du transistor MOS de type P 11, signal noté detec, évolue de la même façon par l'intermédiaire du transistor MOS N 42, lequel est bloqué, et atteint ainsi le niveau de conduction du transistor MOS N 46, lequel se remet à conduire de manière analogue à la première phase dite "rapide", cette nouvelle phase constituant une troisième phase dite "rapide" du signal de commande cmde1N.

On indique d'une manière générale, que le signal de sortie Vs délivré par l'étage de sortie 1, représente l'inverse ou signal complémenté du signal représentatif de la variable logique INBUF lorsque l'étage de sortie 1 est connecté.

De la même manière, le deuxième signal de validation de commutation TRISB constitue en fait un signal de désactivation supprimant le transfert du signal représentatif de la variable logique INBUF sur le signal de sortie Vs.

On indique enfin que le premier signal de validation de commutation TRISP constitue en fait un signal de désactivation du transistor MOS P 11 de l'étage de sortie 1 connecté entre la tension d'alimentation VCC et le point de sortie délivrant le signal de sortie Vs. Le signal de sortie Vs est actif lorsque le signal TRISB est actif ou juste avant l'établissement du signal représentatif de la variable logique INBUF lors de deux transferts consécutifs.

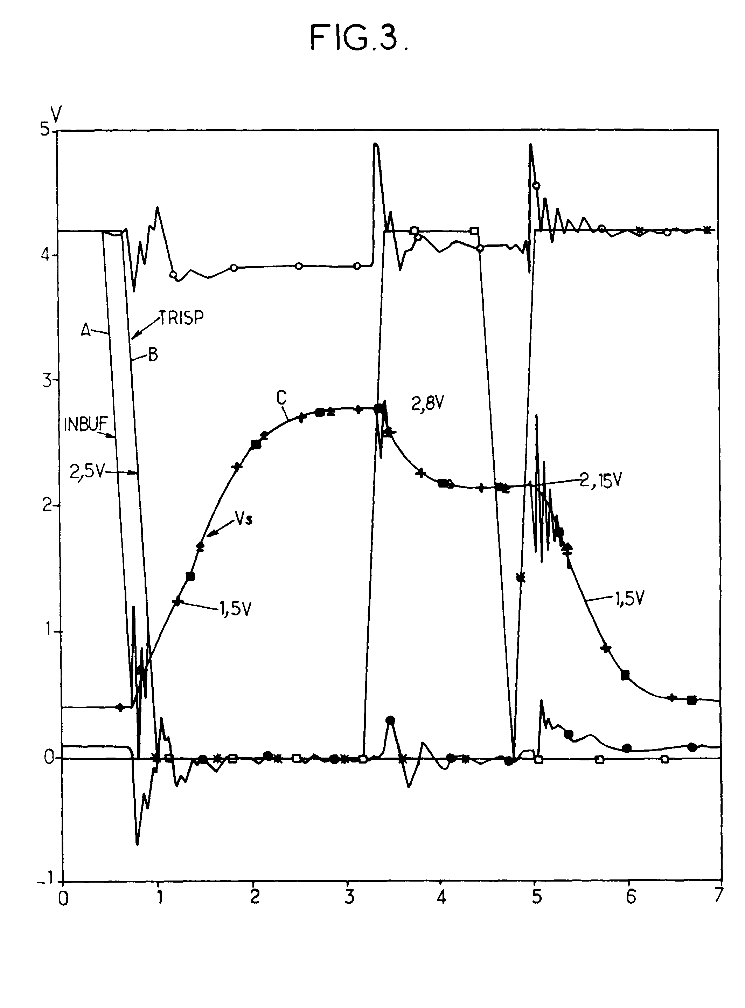

Une représentation des chronogrammes obtenus aux points de test A, B, C de la figure 1 est donnée en figure 3, le signal Vs relevé au point de test C présentant bien le niveau de commutation dit "intermédiaire" sur commande par le signal TRISP relevé au point de test B.

On a ainsi décrit un circuit de sortie pour circuit intégré de type TTL-CMOS particulièrement avantageux dans la mesure où ce circuit, par l'instauration d'un niveau de commutation intermédiaire entre le niveau logique haut et le niveau logique bas, permet, d'une part, de réduire le temps de commutation et, d'autre part, de diminuer le niveau de bruit global de l'étage de sortie, ce qui permet d'améliorer les conditions opératoires de ce dernier.

## Revendications

1. Circuit de sortie pour circuit intégré TTL-CMOS, comprenant un circuit d'entrée d'une variable logique (INBUF) à un niveau haut respectivement à un niveau bas, ledit circuit de sortie comprenant :

- un étage de sortie (1) formé par un transistor MOS (11) de type P et un transistor MOS (12) de type N en parallèle, connectés en cascade avec un transistor MOS (13) de type N de validation, entre une tension d'alimentation (Vcc) et une tension de référence, ledit étage de sortie (1) pouvant être connecté ou non connecté par l'intermédiaire desdits transistors et un premier (TRISP) et un deuxième (TRISB) signal de validation de commutation et délivrant en un point de sortie de cet étage de sortie, point commun entre le transistor de validation (13) et les transistors MOS (11), (12) en parallèle, un signal de sortie (Vs),
- des premiers (2) moyens de commande de commutation dudit transistor MOS (11) de type P, lesdits premiers (2) moyens de commande de commutation étant connectés audit circuit d'entrée d'une variable logique recevant un signal représentatif de ladite variable logique (INBUF) et ledit premier signal de validation de commutation (TRISP) et délivrant un signal de commande de commutation intermédiaire positif (cmde1P) audit transistor MOS (11) de type P ;
- des deuxièmes (3) moyens de commande de commutation dudit transistor MOS (13) de type N de validation en cascade avec les transistors MOS P (11) et N (12) en parallèle, lesdits deuxièmes (3) moyens de commande de commutation étant connectés audit circuit d'entrée d'une variable logique et recevant ledit signal représentatif de ladite variable logique (INBUF) et ledit deuxième signal de validation de commutation (TRISB) et délivrant un signal de commande de commutation (cmd0) égale au produit logique NON-ET de ces signaux audit transistor MOS (13) de type N de validation ;
- des troisièmes (4) moyens de commande de commutation dudit transistor MOS (12) de type N en parallèle, opérant en contre-réaction de la tension de sortie délivrée par l'étage de sortie (1), lesdits troisièmes (4) moyens de commande de commutation comportant au moins :

  • un circuit (41-43) de détection dudit signal de sortie (Vs) interconnecté entre la tension de sortie (Vs) et la tension d'alimentation (Vcc) et délivrant, à partir dudit signal représentatif de la variable logique (INBUF), du deuxième signal de validation de commutation complémenté ($\overline{TRISB}$) et dudit signal de sortie (Vs) un signal détecté (detec) représentatif du signal de sortie (Vs), et

- un étage (44-47) de type inverseur permettant, à partir d'un signal résultant (sel1N), produit logique NON-ET dudit deuxième (TRISB) signal de validation de commutation et dudit signal représentatif de la variable logique complémenté ($\overline{INBUF}$), et dudit signal détecté (detec), d'engendrer un signal de commande de commutation (cmde1N) dudit transistor MOS (12) de type N,

ledit premier signal de validation de commutation (TRISP) constituant un signal de désactivation du transistor MOS (11) de type P et ledit deuxième signal de validation de commutation (TRISB) constituant un signal de désactivation supprimant le transfert dudit signal représentatif de la variable logique (INBUF) sur le signal de sortie (Vs) et, lesdits premiers (2) et troisièmes (4) moyens de commande de commutation étant commandés successivement à partir de la transition d'un niveau logique haut à un niveau logique bas dudit signal représentatif de la variable logique (INBUF), de façon à engendrer un niveau de commutation intermédiaire appartenant au niveau logique haut, ce qui permet d'améliorer le temps de commutation résultant entre niveaux, les deuxièmes (3) moyens de commande étant commandés à partir de la transition d'un niveau logique bas à un niveau logique haut dudit signal représentatif de la variable logique (INBUF).

2. Circuit selon la revendication 1, caractérisé en ce que lesdits premiers moyens de commande de commutation comportent, connectés en cascade :

   - un circuit (20) de type NON-OU recevant sur ses entrées de commande de commutation ledit signal (INBUF) représentatif de ladite variable logique et ledit premier signal de validation de commutation (TRISP) pour délivrer un signal de pré-commande de commutation intermédiaire (sel1P),
   - un circuit (21) de mise en forme dudit signal de pré-commande de commutation intermédiaire recevant ce signal (sel1P) et délivrant à l'électrode de grille dudit transistor MOS de type P ledit signal de commande de commutation intermédiaire positif (cmde1P).

3. Circuit selon la revendication 1 ou 2, caractérisé en ce que les deuxièmes moyens de commande de commutation du transistor de type N en cascade avec les transistors MOS N et P en parallèle comportent :

   - une porte logique (30) de type NON-ET recevant un signal représentatif de ladite variable logique d'entrée (INBUF) et le deuxième signal de validation de commutation (TRISB), et délivrant un signal logique correspondant,
   - un étage (31) de mise en forme recevant ledit signal correspondant et délivrant le signal de commande du transistor MOS N en cascade.

4. Circuit selon l'une des revendications 1 à 3, caractérisé en ce que ledit circuit de détection dudit signal de sortie (Vs) comporte au moins :

   - une porte logique de type NON-OU (41) recevant sur ses entrées de commutation ledit signal représentatif de la variable logique (INBUF) et ledit deuxième signal de validation de commutation complémenté ($\overline{TRISB}$), et délivrant un signal logique correspondant,
   - un circuit de type inverseur comportant deux transistors MOS N (42) et P (43) connectés en cascade entre la sortie de l'étage de sortie délivrant ledit signal de sortie (Vs) et la tension d'alimentation (Vcc), la grille de ces transistors recevant ledit signal logique correspondant et le point commun de ces transistors délivrant ledit signal détecté (detec), représentatif de la tension de sortie (Vs).

5. Circuit selon l'une des revendications 1 à 3 et 4, caractérisé en ce que ledit étage (44-47) de type inverseur comprend au moins, connectés en cascade :

   - un étage de commutation formé par deux transistors MOS N (46) et P (47) connectés en parallèle, entre la tension d'alimentation (Vcc) et un point commun, la grille du transistor MOS P (47) étant reliée à la tension de référence et la grille du transistor MOS N (46) recevant ledit signal détecté (detec) ;
   - un circuit inverseur de sortie formé par deux transistors MOS N (44) et P (45) connectés en cascade entre ce point commun et la tension de référence, la grille de ces transistors MOS N (44) et P (45) recevant ledit signal résultant (sel1N) produit logique NON-ET dudit deuxième (TRISB) signal de validation de commutation et dudit signal représentatif de la variable logique complémentée ($\overline{INBUF}$), le point commun des transistors MOS N (44) et P (45) de ce circuit inverseur de sortie délivrant ledit signal de commande de commutation (cmde1N) du transistor MOS N (12).

**Patentansprüche**

1. Ausgangsschaltung für einen integrierten TTL-CMOS-Schaltkreis mit einer auf ein hohes Niveau bzw. ein niedriges Niveau schaltvariablen Ein-

gangsschaltung (INBUF), wobei die Ausgangs-schaltung umfaßt:

- eine Ausgangsstufe (1), die durch einen MOS-Transistor (11) des p-Typs und einen parallelen MOS-Transistor (12) des n-Typs gebildet wird, welche kaskadenartig mit einem Freigabe-MOS-Transistor (13) des n-Typs zwischen einer Versorgungsspannung (Vcc) und einer Bezugsspannung verbunden sind, wobei die Ausgangsstufe (1) mit Hilfe der Transistoren und eines ersten (TRISP) und eines zweiten (TRISB) Signals zur Schaltungsfreigabe verbunden oder nicht-verbunden sein kann und am Ausgabepunkt dieser Ausgangsstufe, einem gemeinsamen Punkt zwischen dem Freigabetransistor (13) und den parallelen MOS-Transistoren (11, 12), ein Ausgangssignal (Vs) liefert,

- erste Steuermittel (2) zur Schaltung des MOS-Transistors (11) des p-Typs, wobei die ersten Steuermittel (2) zur Schaltung mit der schaltvariablen Eingangsschaltung verbunden sind und ein Signal, das der Schaltvariablen (INBUF) repräsentativ ist, und das erste Freigabesignal der Schaltung (TRISP) erhalten, und dem MOS-Transistor (11) des p-Typs ein positives Zwischensignal (cmde1P) zur Schaltungssteuerung liefern;

- zweite Steuermittel (3) zur Schaltung des MOS-Freigabetransistors (13) des n-Typs, der mit dem p-MOS-Transistor (11) und dem parallelen n-MOS-Transistor (12) kaskadenförmig ist, wobei die zweiten Mittel (3) zur Schaltungssteuerung mit der schaltvariablen Eingangsschaltung verbunden sind und das der Schaltvariablen (INBUF) repräsentative Signal und das zweite Signal der Schaltungsfreigabe (TRISB) erhalten und ein Signal zur Schaltungssteuerung (cmd0) gleich dem logischen NEIN/UND-Produkt dieser Signale des MOS-Freigabetransistors (13) des n-Typs liefern;

- dritten Mitteln (4) zur Schaltungssteuerung des parallelen MOS-Transistors (12) des n-Typs, die als Gegenreaktion auf die durch die Ausgangsstufe (1) gelieferte Ausgangsspannung arbeiten, wobei die dritten Mittel (4) zur Schaltungssteuerung wenigstens umfassen:

  • eine Erfassungsschaltung (41-43) des Ausgangssignals (Vs), die zwischen der Ausgangsspannung (Vs) und der Versorgungsspannung (Vcc) geschaltet ist und, ausgehend von dem Bezugssignal der Schaltvariablen (INBUF), von dem komplementären zweiten Schaltungsfreigabesignal ($\overline{TRISB}$) und von dem Ausgangssignal (Vs) ein erfaßtes Signal (DETEC) liefert, das dem Ausgangssignal (Vs) repräsentativ ist, und

  • eine Inversionsstufe (44-47), die gestattet, ausgehend von einem resultierenden Signal (sel1N), dem logischen NEIN/UND-Produkt des zweiten Schaltungsfreigabesignals (TRISB) und des der Schaltvariablen repräsentativen Komplementärsignals ($\overline{INBUF}$) und dem erfaßten Signal (detec), ein Schaltungssteuersignal (cmde1N) des MOS-Transistors (12) des n-Typs zur erzeugen,

wobei das erste Signal zur Schaltungsfreigabe (TRISP) ein Deaktivierungssignal des MOS-Transistors des p-Typs bildet und das zweite Signal zur Schaltungsfreigabe (TRISB) ein Deaktivierungssignal bildet, das die Übertragung des der Schaltvariablen (INBUF) repräsentativen Signals auf das Ausgangssignal (Vs) unterdrückt, und das erste (2) und dritte (4) Mittel zur Schaltungssteuerung aufeinanderfolgend gesteuert werden, ausgehend von dem Übergang eines hohen logischen Niveaus auf ein niedriges logisches Niveau des der Schaltvariablen (INBUF) repräsentativen Signals, derart, daß ein mittleres Schaltniveau erzeugt wird, das dem hohen logischen Niveau zugeordnet ist, was erlaubt. die sich zwischen den Niveaus ergebenden Schaltzeiten zu verbessern, wobei die zweiten Steuermittel (3) ausgehend von dem Übergang von einem tiefen logischen Niveau zu einem hohen logischen Niveau des der Schaltvariablen (INBUF) repräsentativen Signals gesteuert werden.

**2.** Schaltung nach Anspruch 1, dadurch gekennzeichnet, daß die ersten Schaltungssteuermittel umfassen, verbunden in Kaskade:

- eine NEIN-ODER-Schaltung (20), die auf ihren Eingängen der Schaltungssteuerung das der Schaltvariablen (INBUF) repräsentative Signal und das erste Schaltungsfreigabesignal (TRISP) erhält, um ein dazwischen liegendes Schaltungs-Vorsteuersignal (sel1P) zu liefern,

- eine Formatierungsschaltung (21) des dazwischen liegenden Schaltungs-Vorsteuersignals, die dieses Signal (sel1P) erhält und an die Steuerelektrode des MOS-Transistors des p-Typs das positive Zwischensignal zur Schaltungssteuerung (cmde1P) liefert.

**3.** Schaltung nach Anspruch 1 oder 2, dadurch gekennzeichnet, daß die zweiten Schaltungssteuermittel des mit den parallelen n - und p-MOS-Transistoren kaskadenförmigen Transistor des n-Typs umfassen:

- ein logisches NEIN-UND-Tor (30), das ein der Schaltvariablen des Eingangs (INBUF) repräsentatives Signal und das zweite Schaltungsfreigabesignal (TRISB) erhält und ein entsprechendes logisches Signal liefert,
- eine Formatierungsstufe (31), die das entsprechende Signal erhält und das Steuersignal des n-MOS-Transistors in Kaskade liefert.

4. Schaltung nach einem der Ansprüche 1 bis 3, dadurch gekennzeichnet, daß die Erfassungsschaltung des Ausgangssignals (Vs) wenigstens umfaßt:

- ein logisches NEIN-ODER-Tor (41), das auf seinen Schaltungseingängen das der Schaltvariablen (INBUF) repräsentative Signal und das komplementäre zweite Signal der Schaltungsfreigabe ($\overline{TRISB}$) erhält und ein entsprechendes logisches Signal liefert,
- eine Inversionsschaltung mit zwei MOS-Transistoren des n-Typs (42) und des p-Typs (43), die kaskadenartig zwischen dem Ausgang der Ausgangsstufe verbunden sind und das Ausgangssignal (Vs) und die Versorgungssteuerung (Vcc) liefern wobei das Gate dieser Transistoren das entsprechende logische Signal erhält und der gemeinsame Punkt dieser Transistoren das erfaßte Signal (detec) liefert, das der Ausgangsspannung (vs) repräsentativ ist.

5. Schaltung nach einem der Ansprüche 1 bis 3 und 4, dadurch gekennzeichnet, daß die Inversionsstufe (44 bis 47) wenigstens umfaßt, verbunden in Kaskade:

- eine Schaltungsstufe, die durch zwei parallel verbundene MOS-Transistoren des n-Typs (46) und des p-Typs (47) zwischen der Versorgungsspannung (Vcc) und einem gemeinsamen Punkt gebildet ist. wobei das Gate des p-MOS-Transistors (47) mit der Bezugsspannung verbunden ist und das Gate des n-MOS-Transistors (46) das erfaßte Signal (detec) erhält;
- eine Ausgangs-Inversionsschaltung, die durch zwei kaskadenartig verbundene MOS-Transistoren des n-Typs (44) und des p-Typs (45) zwischen dem gemeinsamen Punkt und der Bezugsspannung gebildet ist, wobei das Gate dieser MOS-Transistoren des n-Typs (44) und des p-Typs (45) das Signal (sel1N) erhält, das sich als logisches NEIN-UND-Produkt des zweiten (TRISB) Schaltungsfreigabesignals und des der komplementären Schaltvariablen ($\overline{INBUF}$) repräsentativen Signals ergibt, wobei der gemeinsame Punkt der MOS-Transistoren des n-Typs (44) und des p-Typs (45) dieser Ausgangs-Inversionsschaltung das Signal zur Schaltungssteuerung (cmde1N) des n-MOS-Transistors (12) liefert.

## Claims

1. Output circuit for an integrated TTL-CMOS circuit, comprising an input circuit for a logic variable (INBUF) at a high level and a low level respectively, said output circuit comprising :

- an output stage (1) formed by a P-type MOS transistor (11) and an N-type MOS transistor (12) in parallel, which are connected in cascade with an N-type MOS enabling transistor (13) between a power supply voltage (Vcc) and a reference voltage, said output stage (1) possibly being connected or not connected by means of said transistors and of first (TRISP) and second (TRISB) switching enable signals, and delivering an output signal at an output point of said output stage, a common point between said enabling transistor (13) and the MOS transistors (11) and (12) in parallel,
- first switching control means (2) for said P-type MOS transistor (11), said first switching control means (2) being connected to said input circuit for a logic variable receiving a signal representing said logic variable (INBUF) and said first enable signal (TRISP), and delivering a positive switching control signal (cmdelP) to said P-type MOS transistor (11);
- second switching control means (3) for said N-type MOS enabling transistor (13) in cascade with the P and N MOS transistors in parallel, said second switching control means (3) being connected to said input circuit for a logic variable (INBUF) receiving thus said signal representing said logic variable (INBUF) and said second switching enable signal (TRISB) and delivering a switching control signal (cmd0) which is the NAND logical product of these signals to said N-type MOS enabling transistor (13);
- third switching control means (4) for said N-type MOS transistor (12) in parallel, operating in a mode of feedback of the output voltage delivered by said output stage (1), said third switching control means (4) comprising at least:

  - a circuit (41-43) for detecting the output voltage (Vs) interconnected between the output voltage (Vs) and the power supply voltage and delivering, from said signal representing said logic variable (INBUF), said complemented second switching enable signal ($\overline{TRISB}$) and said output signal (Vs) a detected signal (detec) representing said output signal (Vs), and

- an inverter-type logic circuit (44-47) allowing to generate, from a resulting signal (sel1N) which is the NAND logical product of said second switching enable signal (TRISB) and said signal representing said complemented logic variable ($\overline{\text{INBUF}}$), from said detected signal (detec) a switching control signal (cmdeIN) for said MOS transistor (12) of N-type,

said first (TRISP) switching enable signal constituting a signal for deactivation of the P MOS transistor (11) and said second switching signal (TRISB) constituting a deactivation signal cancelling the transfer of said signal representing said logic variable (INBUF) on said output signal (Vs), said first (2) and third switching control means (4) being driven successively from a high logic level to a low logic level of said signal representing said logic variable (INBUF) in such a way as to generate an intermediate switching level belonging to the high logic level, which makes it possible to enhance the resultant time for switching between levels, said second switching control means (3) being controlled from a low logic level to a high logic level transition of said signal representing said logic variable (INBUF).

2. Circuit according to Claim 1, characterized in that the said first switching control means include, connected in cascade :

- a NOR-type circuit (20) receiving, on its switching control inputs, said signal (INBUF) representing said logic variable and said first switching enable signal (TRISP) to deliver an intermediate switching pre-control signal (sel1P),
- a circuit (21) for shaping said intermediate switching pre-control signal receiving this signal (sel1P) and delivering a positive intermediate switching control signal (cmde1P) to the gate electrode of said P-type MOS transistor.

3. Circuit according to Claim 1 or 2, characterized in that the second switching control means for the N-type transistor in cascade with the N and P MOS transistors in parallel include:

- a NAND-type logic gate (30) receiving a signal representing said input logic variable (INBUF) and said second switching enable signal (TRISB), and delivering a corresponding logic signal,
- a shaping stage (31) receiving said corresponding logic signal and delivering the control signal for the N MOS transistor in cascade.

4. Circuit according one of the claims 1 to 3, characterized in that said circuit for detecting the output voltage (Vs) comprises at least:

- a NOR-type logic gate (41) receiving on its switching input said signal representing said logic variable (INBUF) and said complemented second switching enable signal ($\overline{\text{TRISB}}$) and delivering a corresponding logic signal,
- an inverter-type circuit comprising two transistors of N-MOS type (42) and P-MOS type (43) which are cascade connected between the output of said output stage delivering said output signal (Vs) and said power supply voltage (Vcc), the gate of said transistors receiving said corresponding logic signal (detec), representing said output signal (Vs).

5. Circuit according to one of the claims 1 to 3 and 4, characterized in that said inverter-type logic circuit (44-47) at least comprises:

- a switching stage comprising two MOS transistors of N and P type (46) and (47) which are connected in parallel, between the power supply voltage (Vcc) and a common point, the gate of the P-MOS transistor (47) being connected to the reference voltage and the gate of the N-MOS transistor (46) receiving the detected signal (detec) ;
- an output inverter circuit comprising two MOS transistors of N (44) and P (45) type which are cascade connected between said common point and said reference voltage, the gate of said MOS transistors N (44) and P (45) receiving said resulting signal (sel1N) which is the NAND logical product of said second switching enable signal (TRISB) and said signal representing said complemented logic variable ($\overline{\text{INBUF}}$), said common point of said MOS transistors N (44) and P (45) of said output inverter circuit delivering said switching control signal (cmdeIN) of said MOS transistor (12) of N-type.

FIG.1.

FIG.2a.

# FIG.2b.

MISE EN FORME 31

# FIG.2c.

# FIG.3.